Europäisches Patentamt

European Patent Office

Office européen des brevets

(11) Publication number: 0 468 505 A2

# EUROPEAN PATENT APPLICATION

(21) Application number: 91112518.5

(51) Int. Cl.5: G06F 5/01

(22) Date of filing: 25.07.91

(30) Priority: 26.07.90 JP 196079/90

(43) Date of publication of application:
29.01.92 Bulletin 92/05

(84) Designated Contracting States:
DE FR GB

(71) Applicant: KABUSHIKI KAISHA TOSHIBA
72, Horikawa-Cho Saiwai-ku
Kawasaki-shi Kanagawa-ken(JP)

(72) Inventor: Omote, Kazuyuki
2-19-41-106, Nakatehara
Kohoku-ku, Yokohama-shi(JP)

(74) Representative: Lehn, Werner, Dipl.-Ing. et al
Hoffmann, Eitle & Partner Patentanwälte
Arabellastrasse 4
W-8000 München 81(DE)

(54) Barrel shifter.

(57) A barrel shifter comprises an alignment circuit formed from two cell arrays (6a and 6b) comprising registers (A0 to A7 and B0 to B7) provided in series for receiving a 2n-bit data row as input and outputting one n-bit data row as one item of data and another n-bit data row as one item of data shifted by n bits aligned in a predetermined arrangement; and a selector group (13 to 16) wherein the shift data (basic data) is input, the basic data is shifted by k-bits only (where k < n), and the k-bit shifted data is output, or, the basic data is output without modification, wherein the selector group (13 to 16) comprises a plurality of stages, each of the stages comprises n + k selectors and the bit data row output from each stage is input to the subsequent stage, the selectors of 0 to (n-1) bits in each stage for shifting k bits (where k < n) is provided, corresponding to 0 to (n-1) bits of data in the alignment circuit, and the selectors of n to (n-1 + k) bits in each stage are separated by k bits from the corresponding selectors of 0 to (n-1) bits in the stage, respectively.

FIG.5

## BACKGROUND OF THE INVENTION

### Field of the Invention

The present invention relates to a barrel shifter with a cell array for modifying an input data arrangement to a predetermined arrangement, then outputting a shifted data, and, in particular, relates to the layout of the cell array.

### Description of the Prior Art

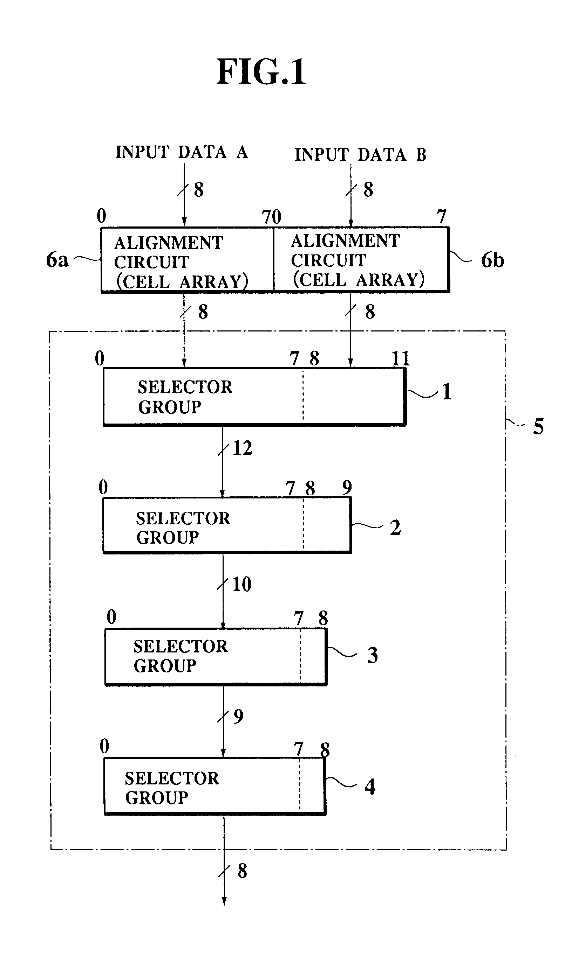

FIG. 1 is a configuration diagram of an example of a conventional barrel shifter provided, on its input side, with a cell array which can shift a plurality of bits at one time to modify the bit arrangement of the input data.

The 8-bit barrel shifter shown in FIG. 1 is capable of shifting from 0 to 8 bits at one time. A 16-bit data row obtained from a cell array 6a in which eight bits of input data A are arranged and a cell array 6b in which eight bits of input data B are arranged is shifted by means of a cell array 5 comprising four selector groups 1 to 4 which are cocatenatedly arranged, and is output as an 8-bit data row. Each of the selector groups 1 to 4 comprise a plurality of selectors which selectively outputs one item of bit data from either the bit data from the thus-obtained bit data rows or bit data from bit data rows which are shifted by a predetermined number of bits.

The selector group 1 comprises twelve selectors. A sixteen-bit data row obtained from the cell arrays 6a, 6b is shifted by four bits and supplied to the selector group 2 as a 12-bit data row obtained from the selector group 1 is shifted by two bits and supplied to the selector group 3 as a 10-bit data row. The selector group 3 comprises nine selectors. The 10-bit data row obtained from the selector group 1 is shifted by one bit and supplied to the selector group 4 as a 9-bit data row. The selector group 4 comprises nine selectors. The 9-bit data row obtained from the selector group 3 is shifted by one bit and output as 8-bit output data.

The barrel shifter performs a 0 to 8-bit shift of the sixteen bits of input data A, B from the full cell array 5 by suitably combining the respective shift amounts of the four selector groups 1 to 4.

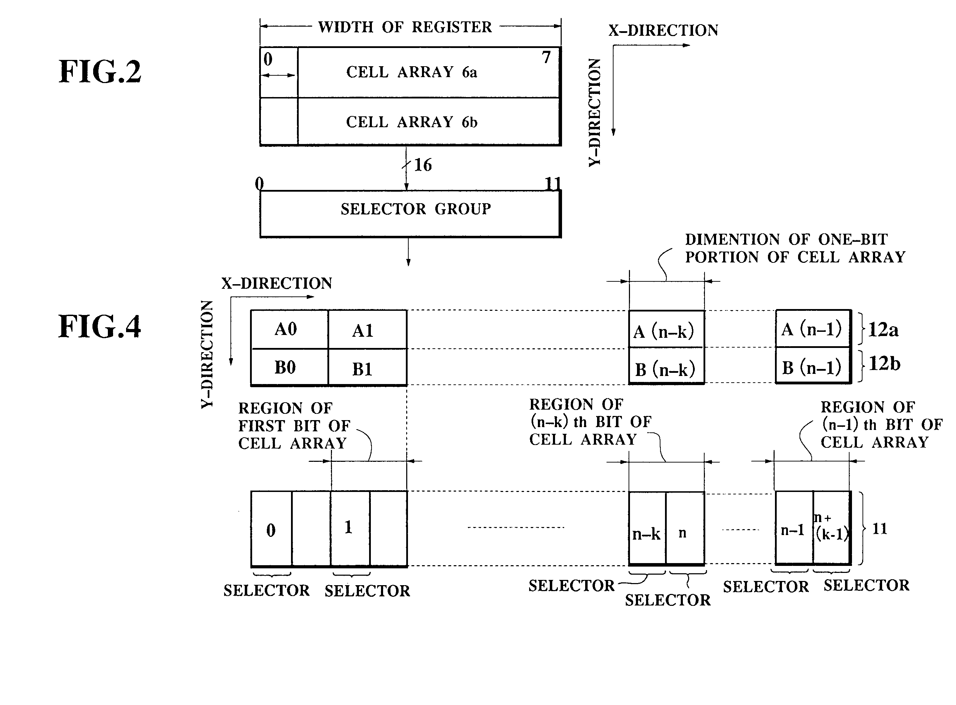

In this barrel shifter layout, the size of the shifter generally conforms to the size of the register. Therefore the cell array 6a, 6b have a two-stage stacked layout in the Y-direction, as illustrated in FIG. 2. The layout is usually designed so that the size of a 1-bit portion of the cell arrays 6a, 6b matches the size of a 1-bit portion of the register. The size of the selector in the respective selector groups 1 to 4 is adequately smaller than the size of a 1-bit portion of the register. The selector can therefore be comparatively freely arranged in the X-direction of FIG. 2 in this type of layout.

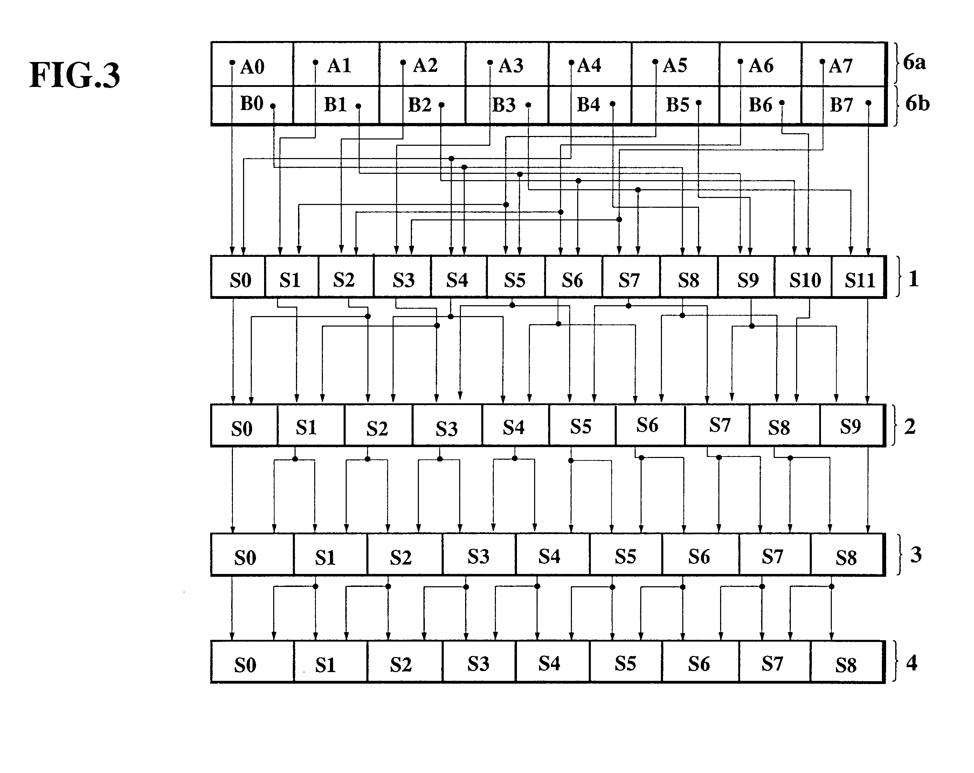

In this 8-bit barrel shifter, when the selector is arranged, for example, in ascending order (column order) the layout shown in FIG. 3 is obtained.

In FIG. 3 a selector S0 of the selector group 1, for example, receives an item of bit data A0 from the $0^{th}$ bit and an item of bit data A4 from the $4^{th}$ bit of the cell array 6a. In both cases these bit data items are selected on the basis of a selection signal which has been omitted from the drawing. Specifically, when the bit data A0 is selected, a shift is not performed on the selector group 1, but when the bit data A4 is selected, a 4-bit shift is performed on the data passing through. The other selectors also operate in the same manner, The selectors of the selector groups 1 to 4 are wired as shown in FIG. 3 so that the data rows are shifted only the amount of the shift for the respective selector groups 1 to 4, for the data rows passing through the respective selector groups 1 to 4.

With the above-described layout of a conventional barrel shifter, as shown in FIG. 3, the selectors of the selector groups 1 to 4 are allotted in ascending order of bits at a uniform spacing in the X-direction of the cell arrays 6a, 6b. There are no rules which determine the bit positions of the cell arrays 6a, 6b (A0 to A7, B0 to B7) and the initial stage of the selectors (S0 to S11) of the selector group 1.

Because of this, the wiring connections between the cell arrays 6a, 6b and the initial stage of the selector group 1 becomes complicated, and if one bit of the cell array is taken as the unit length, the maximum length of the connecting Wiring exceeds n/2 bits (i.e. 4 bits).

This gives rise to the drawbacks whereby the amount of area taken up by the writing region increase, and the barrel shifter therefore becomes large. In addition, a signal delay is produced because of the increase in the length of the wiring which has an adverse effect on the operating speed of the shifter.

## SUMMARY OF THE INVENTION

An object of the present invention is to provide, with due consideration to the drawbacks of such conventional devices, a barrel shifter which can contribute to reducing the size of the structure and improving the operation speed by reducing the length of wiring and the wiring area by simplifying the layout of the connecting wiring of the barrel shifter.

This object is achieved in the present invention by the provision of a barrel shifter comprising an alignment means formed from two recording means provided in series for receiving a 2n-bit data row as input and outputting a n-bit data row as one item of data and a n-bit data row as one item of data shifted by n bits aligned in a predetermined arrangement; and a selector group wherein shift data (basic data) is input, the basic data is shifted by k-bits only (where k < n), and the k-bit shifted data is output, or, the basic data is output without modification. The selector group comprises a plurality of stages each of which comprises n+k selectors and the bit data row output from each stage is input to the subsequent stage. The selectors of 0 to (n-1) bits in each stage for shifting k bits (where k < n) is provided corresponding to 0 to (n-1) bits of data in the alignment means and the selectors of n to (n-1+k) bits in each stage are separated by k bits from the corresponding selectors of 0 to (n-1) bits in the stage, respectively.

BRIEF DESCRIPTION OF THE DRAWINGS

FIG. 1 is a diagram showing the configuration of a conventional barrel shifter with a cell array
FIG. 2 is a diagram showing the configuration of the cell array contained in the conventional barrel shifter of FIG. 1.
FIG. 3 is a layout diagram of the wiring in the conventional barrel shifter of FIG. 1.
FIG. 4 is a diagram showing the configuration of a cell array and a first stage selector group in a barrel shifter of the present invention.
FIG. 5 is a layout diagram of the wiring in the barrel shifter of the present invention shown in FIG. 4.

DETAILED DESCRIPTION OF THE PREFERRED EMBODIMENTS

Other features of this invention will become apparent in the course of the following description of exemplary embodiments which are given for illustration of the invention and are not intended to be limiting thereof.

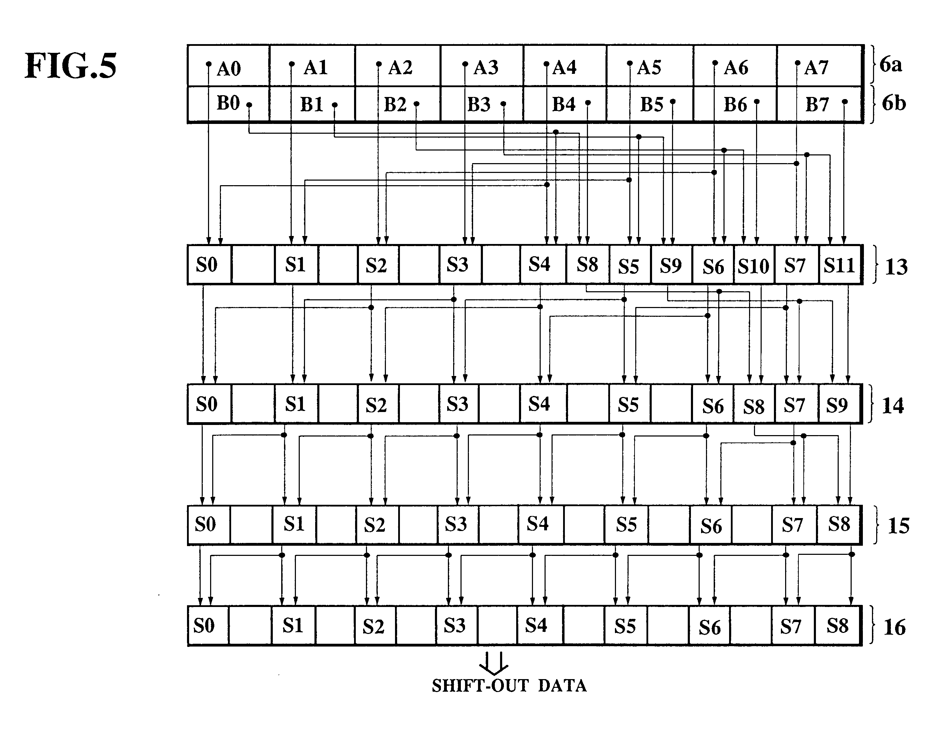

FIG. 4 is a diagram showing the configuration of the main components of a first embodiment of a barrel shifter of the present invention.
On the input side, the barrel shifter is provided with a cell array of the type previously described. This is an n-bit barrel shifter which can shift over a range of 0 to n bits by passing a plurality of bit data rows received from the cell array, each bit data row being 2n bits in width, through a selector group, the individual selectors being cocatenatedly connected.
In this barrel shifter, in a selector group 11 within a plurality of shifter groups for which the shift amount is k bits plurality of shifter groups for which the shift amount is k bits (where k < n), the respective selectors which make up the selector group 11 are arranged as shown in FIG. 4. The selector group 11 is made up of (n + k) selectors, and the selectors 0 to (n-1) among the selectors i (where i = 0 to n + k - 1) are arranged in a bit region corresponding respectively to 0 to (n-1) bits of a plurality of cell arrays 12a, 12b, each of n bits arranged in a two-stage stack.

The selectors n to n + k - 1 among the selectors i are arranged adjacent to a lower order bit selector which is separated from the adjacent selector by only the number of bits in the shift amount k. Specifically, as shown in FIG. 4, the selector n is positioned adjacent to the selector (n-1), with the adjacent selectors being separated only by the shift amount of k bits.

Here, the selector can be positioned and formed at one-ten$^{th}$ of the dimension in the X-direction of a one-bit portion of each of the cell arrays 12a, 12b. Therefore, two adjoining selectors can be positioned separated by the width in the X-direction of the one-bit portion. Accordingly, the two selectors i, i + k, are positioned in the selector group 11 having the shift amount of k bits, separated y an amount corresponding to the region of the i$^{th}$ bit (where(i≥(n-k)).

With a selector of this configuration, in the case where a shift is not performed, the respective selector i in the selector group is connected by wiring to the selector i corresponding to the same bit of the previous stage, and in the case where a k-bit shift is performed, the respective selector i in the selector group is connected by writing to the selector (i + k) of the previous stage.

A specific application of the above-described arrangement method for the first embodiment of the present invention on a barrel shifter will now be described.
FIG. 5 is a diagram showing the actual configuration of an application of the 8-bit barrel shifter of this invention.
FIG. 5 shows the configuration of the barrel shifter provided on the input side with the same cell arrays 6a, 6b shown in FIG. 3. The barrel shifter comprises a first selector group 13 which receives a 16-bit data row from the cell arrays 6a, 6b and performs a 4-bit shift; a second selector group 14 which receives a 12-bit data row from the first selector group 13 and performs a 2-bit shift; a third selector group 15 which receives a 10-bit data row from the second selector group 14 and performs a 1-bit shift; and a fourth selector group 16 which receives a 9-bit data from the third selector group 15 and performs a 1-bit shift.
The first selector group 13 comprises the 12 selectors S0 to S11. The selectors S0 to S7 are arranged in the regions of the bits corresponding to the regions of the 0 to 7$^{th}$ bits of the cell arrays 6a, 6b respectively. The selectors S8 to S11 are arranged adjacent to the selectors corresponding to the bit data separated by four bits respectively. Specifically, the selector S8 is adjacent to the selector S4, the selector S9 to the selector S5, the selector S10 to the selector S6, and the selector S11 to the selector S7.

In this arrangement, the selectors S0 to S7 are wired to the 0 to $7^{th}$ bits A0 to A7 respectively of the cell array 6a and the selectors S0 to S3 are wired to the $4^{th}$ to $7^{th}$ bits A4 to A7 are wired to the 0 to $3^{th}$ bits B0 to B3 respectively of the cell array 6b.

The selector S8 to S11 are wired to the 0 to $3^{rd}$ bits B0 to B3 respectively of the cell array 6b, and in addition, to the $4^{th}$ to $7^{th}$ bits B4 to B7 respectively of the cell array 6a.

In this arrangement, the bits A0 to A3 of the cell array 6a and the bits B4 to B7 of the cell array 6b are in all cases wired to the selector positioned immediately below, specifically, to the selector S0 to S3 and S8 to S11 respectively. In addition, the bits A4 to A7 of the cell array 6a are wired to the selectors positioned immediately below, specifically, to the selectors S4 to S7, and to the selectors S0 to S3 corresponding respectively to the positions four bits in the X-direction of the cell arrays 6a, 6b. Furthermore, the bits B0 to B3 of the cell array 6b are wired to the selectors S4 to S11 corresponding respectively to the positions four bits in the X-direction of the cell arrays 6a, 6b.

In this way, as shown in FIG. 5, a specific set of rules is applied in the positioning of the first stage selectors S0 to S11, as described above. As a result, in the wiring of the cell arrays 6a, 6b to the first stage selector group 13, the wiring network is simple, and the wiring region can be utilized with good efficiently, reducing wasted area. This results in the area taken up by the wiring region decreasing, which contributes to providing a configuration of reduced size.

Even with the maximum length of wiring, the length of the cell arrays 6a, 6b can be held down to 4 $\{(n = 8/2)\}$, which contributes to an improvement in the signal transmission speed for the shifting action.

The second selector group 14 comprises the 10 selectors S0 to S9. The selectors S0 to S7, in the same manner as the selectors S0 to S7 of the first selector group 13, are arranged in the regions of the bits corresponding to the regions of the 0 to $7^{th}$ bits of the cell arrays 6a, 6b respectively. The selector S8 is arranged adjacent to the selector S6 corresponding to the bit data separated by two bits, and is arranged to corresponding to the bit data separated by two bits, and is arranged to correspond to the region of the $6^{th}$ bit (A6 and B6) of the cell arrays 6a, 6b respectively. In addition, the selector S9 is arranged adjacent to the selector S7 corresponding to the bit data separated by two bits, and is arranged to correspond to the region of the $7^{th}$ bit (A7 and B7) of the cell arrays 6a, 6b respectively.

In this arrangement, the selectors S0 to S9 are wired to the selectors S0 to S9 and also to the selectors S2 to S11 respectively of the first selector group 13.

In the same manner, the selectors S0 to S1 and the selectors S10 to S11 respectively of the first selector group 13 are wired to the selectors positioned immediately below, specifically, to the selectors S0 to S1 and S8 to S9 respectively of the second selector group 14. In addition, the selectors S2 to S7 respectively of the first selector group 13 are wired to the selectors S2 to S7 respectively, and to the selectors S0 to S5 corresponding respectively to the positions two bits in the X-direction of the second selector group 14. Furthermore, the selectors S8, S9 of the first selector group 13 are wired to the selectors S6, S8 and to the selectors S7, S9 respectively of the second selector group 14.

In this way, a specific set of rules is applied to the first stage selector group 13 as previously described for the cell arrays 6a, 6b, so that the wiring network is simple and the same effect can be obtained.

The third selector group 15 comprises the 9 selectors S0 to S8. The selectors S0 to S7, in the same manner as selectors S0 to S7 of the first selector group 13, are arranged in the regions of the bits corresponding to the regions of the 0 to $7^{th}$ bits of the cell arrays 6a, 6b respectively. The selector S8 is arranged adjacent to the selector S7 corresponding to the bit data separated by one bit, and is arranged to correspond to the region of the $7^{th}$ bits of the cell arrays 6a, 6b respectively. THe selector S8 is arranged adjacent to the selector S7 corresponding to the bit data separated by one bit, and is arranged to correspond to the region of the $7^{th}$ bit (A7 and B7) of the cell arrays 6a, 6b respectively. The selectors of the $4^{th}$ stage selector group 16 are also arranged in the same manner with respect to the selectors of the $3^{rd}$ stage selector group 15.

In this way, a specific set of rules is applied for the wiring among the specific selectors as shown in FIG. 5 so that the wiring network is simple and the same effect can be obtained as described previously.

Accordingly, with an 8-bit barrel shifter for example, as an application of the present invention, the wiring is simplified making it possible to reduce the total length of wiring, and the area taken up by the wiring is also reduced.

As can be readily understood from the foregoing description, by means of the present invention, a selector of 0 to (n-1) bits among the selectors in a row of selectors for shifting k bits (where k < n) is arranged corresponding to the number of bits of data to be shifted, and the $n^{th}$ and subsequent selectors are positioned adjacent to the selector separated by k bits, so that a specific set of rules can be supplied for connecting the wiring among the selectors, thus simplifying the wiring. As a result, the maximum, wiring length and wiring which can contribute to size reduction and increased operating speeds.

Furthermore, the present invention is not limited to the embodiment described above. THe bit width and the shift amount may be optionally set for the data rows handled.

## Claims

1. A barrel shifter comprising:

an alignment means formed from two recording means (6a and 6b), provided in series for receiving a 2n-bit data row as input and outputting a n-bit data row as one item of data and a n-bit data row as one item of data shifted by n bits aligned in a predetermined arrangement; and

a selector group wherein the shift data (basic data) is input, the basic data is shifted by k-bits only (where k < n), and the k-bit shifted data is output, or, the basic data is output without modification,

wherein the selector group comprises a plurality of stages each of which comprises n + k selectors and the bit data row output from each stage is input to the subsequent stage, the selectors of 0 to (n-1) bits in each stage for shifting k bits (where k < n) is provided, corresponding to 0 to (n-1) bits of data in the alignment means, and the selectors of n to (n-1 + k) bits in each stage are separated by k bits from the corresponding selectors of 0 to (n-1) bits in the stage, respectively.

# FIG.1

INPUT DATA A     INPUT DATA B

/8        /8

0        70         7

6a | ALIGNMENT CIRCUIT (CELL ARRAY) | ALIGNMENT CIRCUIT (CELL ARRAY) | 6b

/8        /8

0        7 8    11

SELECTOR GROUP     1

5

/12

0        7 8   9

SELECTOR GROUP     2

/10

0        7 8

SELECTOR GROUP     3

/9

0        7 8

SELECTOR GROUP     4

/8

**FIG.2**

EP 0 468 505 A2

WIDTH OF REGISTER

X-DIRECTION

0       CELL ARRAY 6a       7

CELL ARRAY 6b

Y-DIRECTION

16

0      SELECTOR GROUP      11

DIMENTION OF ONE-BIT
PORTION OF CELL ARRAY

**FIG.4**

X-DIRECTION

Y-DIRECTION

| A0 | A1 |
|---|---|
| B0 | B1 |

A (n−k)     A (n−1) }12a

B (n−k)     B (n−1) }12b

REGION OF
FIRST BIT OF
CELL ARRAY

REGION OF
(n−k) th BIT OF
CELL ARRAY

REGION OF
(n−1) th BIT OF
CELL ARRAY

| 0 | | 1 | |
|---|---|---|---|

n−k | n

n−1 | n+(k-1) } 11

SELECTOR   SELECTOR

SELECTOR   SELECTOR

SELECTOR   SELECTOR

SELECTOR

FIG.3

# FIG.5

SHIFT-OUT DATA

EP 0 468 505 A2